# FASCICULE DE BREVET EUROPEEN

(11) **EP 3 516 937 B1**
(45) Date de publication et mention de la délivrance du brevet: **06.12.2023**
(21) Numéro de dépôt: 17780474.7
(22) Date de dépôt: 13.09.2017
(51) Int. Cl.: H05K 5/00

(54) **BOITIER DE CALCULATEUR AUTOMOBILE, CALCULATEUR ET VEHICULE CORRESPONDANT**
AUTOMOBILCOMPUTERGEHÄUSE, ZUGEHÖRIGER COMPUTER UND FAHRZEUG
AUTOMOTIVE COMPUTER HOUSING, CORRESPONDING COMPUTER AND VEHICLE

(30) Priorité: 26.09.2016 FR 1659026
(43) Date de publication de la demande: 31.07.2019
(73) Titulaire: Renault s.a.s, 92100 Boulogne Billancourt (FR)
(72) Inventeur: BARROIS, Denis, 78260 Acheres (FR); MEDINA, Serge, 78780 Maurecourt (FR)
(74) Mandataire: Renault Group
(86) Numéro de dépôt international: PCT/FR2017/052435
(87) Numéro de publication internationale: WO 2018/055258

(56) Documents cités:
- US-A- 5 057 971
- US-A1- 2003 056 491
- US-A1- 2010 315 792
- US-B1- 6 272 021

## Description

### 1. Domaine de l'invention

L'invention concerne le domaine des boîtiers de calculateurs embarqués à bord de véhicules automobiles. Elle concerne plus particulièrement un boîtier de calculateur automobile, des calculateurs automobile et un véhicule équipé des calculateurs automobile.

### 2. Art antérieur

Les véhicules actuels sont équipés de dispositifs d'aide à la conduite et d'équipements électroniques de confort nécessitant des capacités de calcul de plus en plus importantes ce qui entraîne une augmentation du nombre de cartes électroniques de calculateur embarquées dans les véhicules.

Une carte électronique de calculateur est classiquement placée dans un boîtier de calculateur pour la protéger contre d'éventuelles détériorations liées notamment aux chocs et vibrations inhérents au fonctionnement d'un véhicule.

Il est connu des boîtiers de calculateur automobile comportant un compartiment destiné à recevoir une carte électronique de calculateur. La carte électronique de calculateur, une fois placée dans le boîtier, est connectée à un câble dont une portion est présente à l'extérieur du boîtier pour connecter électriquement le calculateur à un système électronique, par exemple un dispositif d'aide à la conduite ou un équipement électronique de confort. On connaît aussi la demande de brevet US5057971 qui protège de la poussière les connecteurs extérieurs d'un boîtier de calculateur au moyen d'un carter.

Les véhicules conventionnels comptent ainsi un boîtier de calculateur pour chaque carte électronique de calculateur, ce qui représente une masse et un volume embarqué conséquents. Ainsi, l'augmentation du nombre de cartes électroniques entraîne une augmentation de la masse embarquée et de l'encombrement dans le véhicule allant à l'encontre d'une économie de carburant et d'une réduction de l'impact environnemental.

### 3. Objectifs de l'invention

L'invention propose une solution visant à pallier les inconvénients précités. Un objectif de l'invention est de réduire l'encombrement et la masse induits dans un véhicule par la présence de calculateurs automobiles embarqués.

### 4. Résumé de l'invention

L'invention concerne un boîtier de calculateur automobile destiné à recevoir plusieurs cartes électroniques de calculateur caractérisé en ce qu'il comporte un premier compartiment agencé pour recevoir plusieurs cartes électroniques de calculateur montées parallèlement sur des rails de manière amovible, un deuxième compartiment agencé pour recevoir des câbles de connexion et comprenant des orifices traversant vers l'extérieur du boîtier pour permettre le passage des câbles vers l'extérieur du boîtier, le premier compartiment et le deuxième compartiment ayant une première paroi commune, ladite première paroi comportant au moins un orifice traversant agencé pour recevoir au moins un connecteur pour connecter électriquement une carte électronique de calculateur à un câble, la carte électronique de calculateur étant agencée de sorte que ses bords latéraux coulissent dans les rails et qu'elle est branchée à des connecteurs situés en regard de son bord arrière.. Le premier compartiment permet de rassembler plusieurs cartes électroniques de calculateur dans un même boîtier ce qui permet de réduire le nombre de boîtiers de calculateur nécessaires et donc l'encombrement et la masse induits dans un véhicule par la présence de calculateurs automobiles embarqués. Par ailleurs, le rapprochement des cartes électroniques entre elles obtenu en les plaçant dans un premier compartiment permet de réduire la quantité de câbles nécessaires ce qui contribue à une réduction de coûts de fabrication du véhicule en plus d'une réduction d'encombrement et de masse. Le regroupement des câbles dans un deuxième compartiment et la disposition des connecteurs sur une même paroi permet d'optimiser le câblage.

Selon un mode de réalisation particulier, le boîtier de calculateur automobile comporte en outre un troisième compartiment agencé pour recevoir des cartes électroniques de composants de protection montées parallèlement sur des rails de manière amovible, le troisième compartiment et le deuxième compartiment ayant une deuxième paroi commune, ladite deuxième paroi comportant au moins un orifice traversant agencé pour recevoir au moins un connecteur pour connecter électriquement une carte électroniques de composants de protection à un câble. On entend par composants de protection des relais électriques ou des fusibles. Les relais électriques sont communément appelés contacteurs et réalisent une commutation dans un circuit de puissance en fonction d'une commande issue d'un circuit de commande. La disposition des composants de protection à proximité des cartes électroniques de calculateur permet d'optimiser encore davantage le câblage.

Selon un mode de réalisation particulier, la deuxième paroi est disposée dans le prolongement de la première paroi. La première paroi et la deuxième paroi sont ainsi placées dans un même plan, par conséquent les connecteurs connectés aux cartes électroniques de calculateur et aux cartes électronique de composants de protection sont dans un même plan ce qui simplifie le câblage.

Selon un mode de réalisation particulier, le premier compartiment et le troisième compartiment comportent respectivement une première ouverture et une deuxième ouverture vers l'extérieur à l'opposé respectivement de la première paroi et de la deuxième paroi. La première ouverture et la deuxième ouverture permettent, pendant une opération de maintenance notamment, d'accéder rapidement respectivement aux cartes électroniques de calculateur et aux cartes électroniques de composants de protection.

Selon un mode de réalisation particulier, le boîtier de calculateur automobile comporte en outre au moins un couvercle amovible agencé pour obturer la première ouverture et la deuxième ouverture. Le couvercle amovible permet d'obtenir alternativement un boîtier ouvert, pour permettre une opération de maintenance par exemple, et un boîtier fermé pour protéger efficacement son contenu d'éventuelles détériorations.

Selon un mode de réalisation particulier, le boîtier de calculateur automobile comporte en outre ledit au moins un connecteur.

Selon un mode de réalisation particulier, le boîtier de calculateur automobile comporte en outre lesdits câbles de connexion.

L'invention concerne également un calculateur automobile caractérisé en ce qu'il comporte un boîtier selon l'invention et lesdites cartes électroniques de calculateur.

L'invention concerne également un véhicule automobile caractérisé en ce qu'il comporte un calculateur automobile selon l'invention.

Selon un mode de réalisation particulier, le véhicule automobile comportant en outre une cave à pied côté passager, le calculateur automobile est placé dans la cave à pied. L'emplacement du calculateur automobile dans la cave à pied permet que le calculateur se situe à proximité des dispositifs d'aide à la conduite et des équipements électroniques de confort classiquement intégrés au tableau de bord pour limiter le câblage nécessaire tout en désencombrant l'espace situé au-dessus du plancher du véhicule.

### 5. Liste des figures

D'autres caractéristiques et avantages innovants ressortiront de la description ci-après, fournie à titre indicatif et nullement limitatif, en référence aux dessins annexés, dans lesquels :
- La figure 1 représente une vue schématique d'un calculateur automobile selon un mode de réalisation de l'invention ;
- La figure 2 représente une vue éclatée du calculateur automobile de la figure 1 ; et
- La figure 3 représente une vue partielle et schématique d'un véhicule comportant un calculateur automobile selon l'invention.
- La figure 4 représente une vue schématique en coupe d'un calculateur automobile selon un mode de réalisation de l'invention.

### 6. Description détaillée

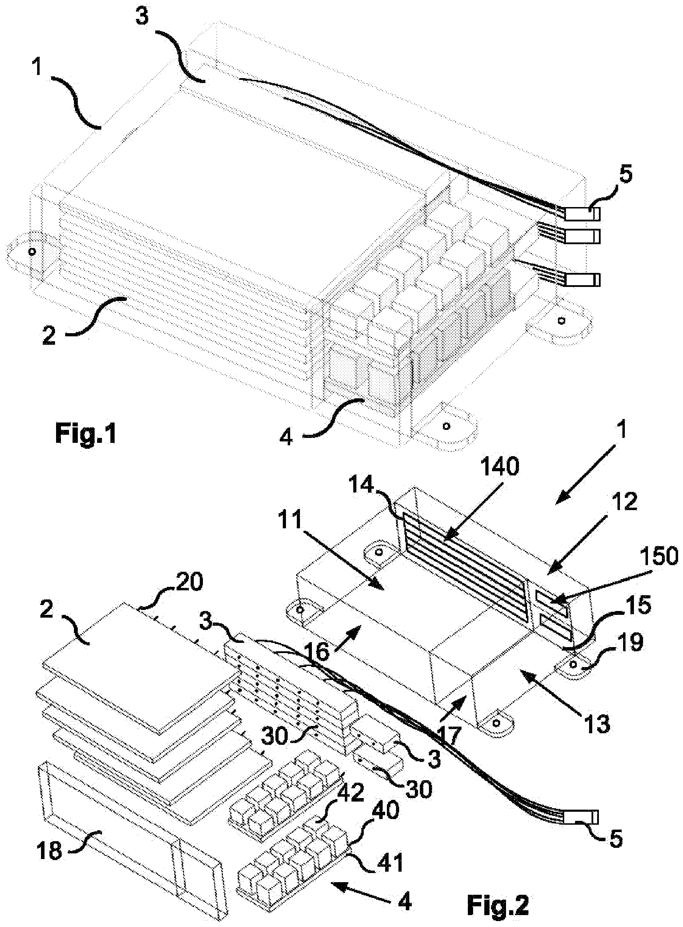

Aux figures 1 et 2 est représenté un calculateur automobile selon un mode de réalisation de l'invention. Le calculateur est destiné à être embarqué dans un véhicule automobile. Le calculateur comporte un boîtier 1, plusieurs cartes électroniques de calculateur 2, des connecteurs 3, des cartes électroniques de composants de protection 4 et des câbles 5.

Le boîtier 1 comporte un premier compartiment 11, un deuxième compartiment 12 et un troisième compartiment 13. Le premier compartiment 11 est séparé du deuxième compartiment 12 par une première paroi 14. Le troisième compartiment 13 est séparé du deuxième compartiment 12 par une deuxième paroi 15, placée dans cet exemple dans le prolongement de la première paroi 14.

La première paroi 14 comporte des orifices traversants 140 agencés pour recevoir des connecteurs 3 pour connecter électriquement une carte électronique de calculateur 2 à un câble 5. La deuxième paroi 15 comporte des orifices traversants 150 agencés pour recevoir des connecteurs 3 pour connecter électriquement une carte électronique de composants de protection 4 à un câble 5.

Le premier compartiment 11 et le troisième compartiment 13 comportent respectivement une première ouverture 16 et une deuxième ouverture 17 vers l'extérieur du boîtier en regard de la première paroi 14 et de la deuxième paroi 15.

Le boîtier comporte en outre un couvercle 18 amovible agencé pour obturer la première ouverture 16 et la deuxième ouverture 17.

Le boîtier comprend également des éléments de fixation 19 agencés pour permettre la fixation du boîtier dans un véhicule automobile. Les éléments de fixation 19 comportent par exemple des pattes faisant saillie du boîtier 1 et percées d'un orifice destiné à recevoir une vis pour une fixation de type vis/écrou du boîtier dans le véhicule. En variante, les éléments de fixation 19 sont collés ou soudés au véhicule.

Les connecteurs 3 sont placés dans les orifices traversants 140 ou 150 de formes adaptées. Les extrémités d'un connecteur 3 s'étendent au-delà de l'orifice traversant 140 ou 150 lorsque le connecteur 3 est placé dans l'orifice traversant 140 ou 150. Les extrémités sont par exemple percées d'un orifice destiné à recevoir une vis pour une fixation de type vis/écrou d'un connecteur 3 dans la première paroi 14 ou la deuxième paroi 15. En variante, les connecteurs 3 sont collés, soudés ou emboîtés dans la première paroi 14 ou la deuxième paroi 15.

Le premier compartiment 11 comporte au moins deux parois latérales reliant la première paroi 14 à la première ouverture 16. Les parois latérales comportent chacune une face interne. Les faces internes des deux parois latérales sont parallèles entre elles. Les faces internes sont équipées de rails (non représentés) disposés selon des rangées s'étendant parallèlement dans une direction reliant la première paroi 14 à la première ouverture 16. Les rails sont disposés par paire, chacune des deux faces internes du premier compartiment comportant un rail de la paire. Les cartes électroniques de calculateur 2 comportent au moins quatre bords dont un bord avant destiné à être en regard de l'ouverture 16, un bord arrière destiné à être en regard de la paroi 14 et deux bords latéraux parallèles entre eux, les deux bords latéraux étant aptes à coulisser simultanément respectivement dans les rails d'une paire. Lorsqu'une carte électronique de calculateur 2 est agencée de sorte que ses bords latéraux coulissent dans des rails, son bord arrière est placé à proximité des connecteurs 3 fixés à la première paroi 16. Le bord arrière présente des fiches 20 de branchement électrique en saillie destinées à être branchées à des connecteurs 3 situés en regard du bord arrière. Les rails et le branchement des fiches 20 dans les connecteurs 3 permettent de maintenir fixée de manière amovible la carte électronique de calculateur 2 dans le compartiment 11.

L'agencement des cartes électroniques de composants de protection 4 dans le troisième compartiment 13 est identique à celui cartes électroniques de calculateur 2 dans le premier compartiment 11, mutatis mutandis.

Chaque câble 5 relie deux connecteurs entre eux à l'intérieur du deuxième compartiment ou relie un connecteur à un composant électronique extérieur au boîtier. Les câbles 5 reliant un connecteur à un composant électronique extérieur au boîtier passent à l'extérieur du boîtier par un orifice traversant effectuant un passage vers l'extérieur dans le deuxième compartiment.

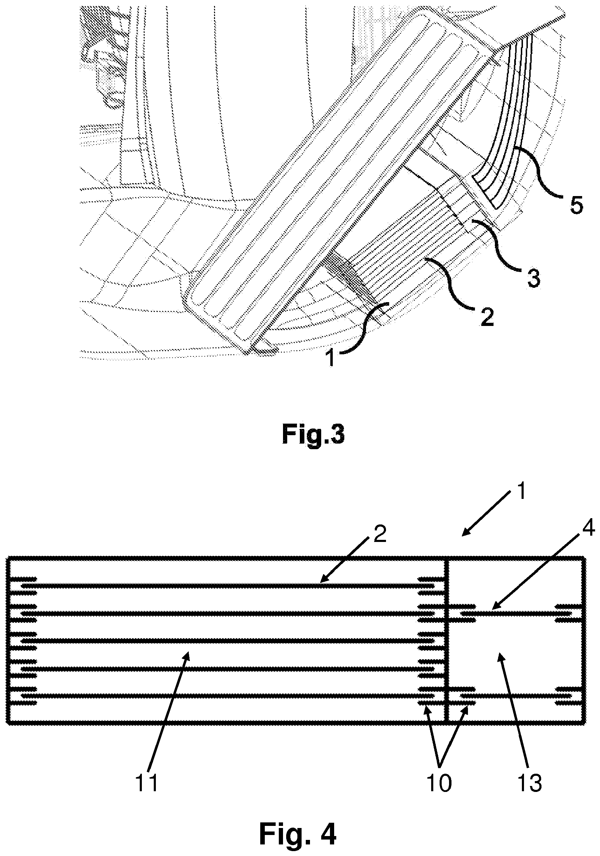

En référence à la figure 3, le boîtier 1 est par exemple fixé sur le plancher du véhicule dans la cave à pieds côté passager. Il est protégé par un repose-pied pour le passager.

En figure 4, la vue schématique en coupe du calculateur 1 correspond à une vue selon un axe perpendiculaire au plan des cartes électroniques 2 et des cartes électroniques de composants de protection 4. Cette vue présente un exemple de positionnement des rails 10 (pour des raisons de lisibilité de même que pour les cartes, tous les rails n'ont pas été identifiés par des flèches) au sein du premier compartiment 11 et du troisième compartiment 13. L'avantage d'un troisième compartiment agence pour recevoir des cartes électroniques de composants de protection montées parallèlement sur des rails 10 de manière amovible est d'obtenir un boîtier organise rationnellement pour permettre une maintenance efficace et rapide lorsque les composants de protection sont à changer. En effet, les composants de protection sont conçus pour céder avant les composants des cartes électroniques de calculateur et sont donc amenés à être changés plus fréquemment. Le fait de regrouper ces composants de protection dans un troisième compartiment dédié et de les organiser en assemblant ces composants sur des cartes montées parallèlement sur des rails 10 de manière amovible permet d'accéder facilement et rapidement au composant de protection visé.

## Revendications

1. Boîtier de calculateur (1) automobile destiné à recevoir plusieurs cartes électroniques de calculateur (2) comportant :
• un premier compartiment (11) agencé pour recevoir plusieurs cartes électroniques de calculateur (2) montées parallèlement sur des rails (10) de manière amovible,
• un deuxième compartiment (12) agencé pour recevoir des câbles (5) de connexion et comprenant des orifices traversant vers l'extérieur du boîtier pour permettre le passage des câbles (5) vers l'extérieur du boîtier, le premier compartiment (11) et le deuxième compartiment (12) ayant une première paroi (14) commune, ladite première paroi (14) comportant au moins un orifice traversant (140) agencé pour recevoir au moins un connecteur pour connecter électriquement une carte électronique de calculateur (2) à un câble (5), la carte électronique de calculateur (2) étant agencée de sorte que ses bords latéraux coulissent dans les rails et qu'elle est branchée à des connecteurs (3) situés en regard de son bord arrière.

2. Boîtier de calculateur (1) automobile selon la revendication 1 **caractérisé en ce qu'**il comporte en outre :
• un troisième compartiment (13) agencé pour recevoir des cartes électroniques de composants de protection (4) montées parallèlement sur des rails (10) de manière amovible,
le troisième compartiment (13) et le deuxième compartiment (12) ayant une deuxième paroi (15) commune, ladite deuxième paroi (15) comportant au moins un orifice traversant (150) agencé pour recevoir au moins un connecteur (3) pour connecter électriquement une carte électroniques de composants de protection (4) à un câble (5).

3. Boîtier de calculateur (1) automobile selon la revendication 2 **caractérisé en ce que** la deuxième paroi (15) est disposée dans le prolongement de la première paroi (14).

4. Boîtier de calculateur (1) automobile selon la revendication 2 ou 3 **caractérisé en ce que** le premier compartiment (11) et le troisième compartiment (13) comportent respectivement une première ouverture (16) et une deuxième ouverture (17) vers l'extérieur respectivement à l'opposé de la première paroi (14) et de la deuxième paroi (15) .

5. Boîtier de calculateur (1) automobile selon la revendication 4 **caractérisé en ce qu'**il comporte en outre au moins un couvercle (18) agencé pour obturer la première ouverture (16) et la deuxième ouverture (17).

6. Boîtier de calculateur (1) automobile selon l'une des revendications 1 à 5 **caractérisé en ce qu'**il comporte en outre ledit au moins un connecteur (3).

7. Boîtier de calculateur (1) automobile selon la revendication 6 **caractérisé en ce qu'**il comporte en outre lesdits câbles (5) de connexion.

8. Calculateur automobile **caractérisé en ce qu'**il comporte un boîtier selon la revendication 7 et lesdites cartes électroniques de calculateur (2).

9. Véhicule automobile **caractérisé en ce qu'**il comporte un calculateur automobile selon la revendication 8.

10. Véhicule automobile selon la revendication 9 **caractérisé en ce que**, le véhicule comportant en outre une cave à pied côté passager, le calculateur automobile est placé dans la cave à pied.

## Patentansprüche

1. Automobilcomputergehäuse (1), welches dazu bestimmt ist, mehrere Computerplatinen (2) aufzunehmen, und aufweist:
• ein erstes Fach (11), das dazu eingerichtet ist, mehrere Computerplatinen (2) aufzunehmen, die lösbar parallel auf Schienen (10) angebracht sind,
• ein zweites Fach (12), das dazu eingerichtet ist, Verbindungskabel (5) aufzunehmen, und Durchgangsöffnungen zur Außenseite des Gehäuses umfasst, um die Durchführung der Kabel (5) zur Außenseite des Gehäuses zu ermöglichen,
wobei das erste Fach (11) und das zweite Fach (12) eine gemeinsame erste Wand (14) aufweisen, wobei die erste Wand (14) mindestens eine Durchgangsöffnung (140) aufweist, die dazu eingerichtet ist, mindestens einen Verbinder aufzunehmen, um eine Computerplatine (2) mit einem Kabel (5) elektrisch zu verbinden, wobei die Computerplatine (2) derart ausgebildet ist, dass ihre Seitenränder in den Schienen gleiten und dass sie an Verbinder (3) angeschlossen ist, die sich gegenüber ihrem hinteren Rand befinden.

2. Automobilcomputergehäuse (1) nach Anspruch 1, **dadurch gekennzeichnet, dass** es außerdem aufweist:
• ein drittes Fach (13), das dazu eingerichtet ist, Platinen von Schutzkomponenten (4) aufzunehmen, die lösbar parallel auf Schienen (10) angebracht sind,
wobei das dritte Fach (13) und das zweite Fach (12) eine gemeinsame zweite Wand (15) aufweisen, wobei die zweite Wand (15) mindestens eine Durchgangsöffnung (150) aufweist, die dazu eingerichtet ist, mindestens einen Verbinder (3) aufzunehmen, um eine Platine von Schutzkomponenten (4) mit einem Kabel (5) elektrisch zu verbinden.

3. Automobilcomputergehäuse (1) nach Anspruch 2, **dadurch gekennzeichnet, dass** die zweite Wand (15) in der Verlängerung der ersten Wand (14) angeordnet ist.

4. Automobilcomputergehäuse (1) nach Anspruch 2 oder 3, **dadurch gekennzeichnet, dass** das erste Fach (11) und das dritte Fach (13) eine erste Öffnung (16) bzw. eine zweite Öffnung (17) zur Außenseite hin gegenüber der ersten Wand (14) bzw. der zweiten Wand (15) aufweisen.

5. Automobilcomputergehäuse (1) nach Anspruch 4, **dadurch gekennzeichnet, dass** es außerdem mindestens eine Abdeckung (18) aufweist, die dazu eingerichtet ist, die erste Öffnung (16) und die zweite Öffnung (17) zu verschließen.

6. Automobilcomputergehäuse (1) nach einem der Ansprüche 1 bis 5, **dadurch gekennzeichnet, dass** es außerdem den mindestens einen Verbinder (3) aufweist.

7. Automobilcomputergehäuse (1) nach Anspruch 6, **dadurch gekennzeichnet, dass** es außerdem die Verbindungskabel (5) aufweist.

8. Automobilcomputer, **dadurch gekennzeichnet, dass** er ein Gehäuse nach Anspruch 7 und die Computerplatinen (2) aufweist.

9. Kraftfahrzeug, **dadurch gekennzeichnet, dass** es einen Automobilcomputer nach Anspruch 8 aufweist.

10. Kraftfahrzeug nach Anspruch 9, **dadurch gekennzeichnet, dass**, wenn das Fahrzeug außerdem einen Fußraum auf der Beifahrerseite aufweist, der Automobilcomputer in dem Fußraum angeordnet ist.

## Claims

1. Automotive computer housing (1) intended to receive several electronic computer boards (2) and comprising:
• a first compartment (11) designed to receive several electronic computer boards (2) mounted in parallel removably on rails (10),
• a second compartment (12) designed to receive connection cables (5) and comprising through-orifices leading to outside the housing so as to allow the cables (5) to be led out of the housing,
the first compartment (11) and the second compartment (12) having a first wall (14) in common, said first wall (14) comprising at least one through-orifice (140) designed to receive at least one connector for electrically connecting an electronic computer board (2) to a cable (5), the electronic computer board (2) being arranged in such a way that its lateral edges slide in the rails and that it is connected to connectors (3) situated facing its rear edge.

2. Automotive computer housing (1) according to Claim 1, **characterized in that** it further comprises:
• a third compartment (13) designed to receive electronic protection-components boards (4), which boards are mounted in parallel removably on rails (10),
the third compartment (13) and the second compartment (12) having a second wall (15) in common, said second wall (15) comprising at least one through-orifice (150) designed to receive at least one connector (3) for electrically connecting an electronic protection-components board (4) to a cable (5).

3. Automotive computer housing (1) according to Claim 2, **characterized in that** the second wall (15) is positioned in the continuation of the first wall (14).

4. Automotive computer housing (1) according to Claim 2 or 3, **characterized in that** the first compartment (11) and the third compartment (13) respectively comprise a first opening (16) and a second opening (17) to the outside, these openings being respectively opposite the first wall (14) and opposite the second wall (15).

5. Automotive computer housing (1) according to Claim 4, **characterized in that** it further comprises at least one cover (18) designed to close off the first opening (16) and the second opening (17).

6. Automotive computer housing (1) according to one of Claims 1 to 5, **characterized in that** it further comprises said at least one connector (3).

7. Automotive computer housing (1) according to Claim 6, **characterized in that** it further comprises said connecting cables (5).

8. Automotive computer, **characterized in that** it comprises a housing according to Claim 7 and said electronic computer boards (2).

9. Automotive vehicle, **characterized in that** it comprises an automotive computer according to Claim 8.

10. Automotive vehicle according to Claim 9, **characterized in that**, with the vehicle further comprising a footwell on the passenger side, the automotive computer is placed in the footwell.
